(19) Europäisches Patentamt
European Patent Office
Office européen des brevets

(11) **EP 3 381 114 B1**

(12) **FASCICULE DE BREVET EUROPEEN**

(45) Date de publication et mention de la délivrance du brevet:
**08.04.2020 Bulletin 2020/15**

(21) Numéro de dépôt: **16791550.3**

(22) Date de dépôt: **26.10.2016**

(51) Int Cl.:
*H02M 7/00* (2006.01)          *H02M 1/34* (2007.01)

(86) Numéro de dépôt international:
**PCT/EP2016/075790**

(87) Numéro de publication internationale:
**WO 2017/089062 (01.06.2017 Gazette 2017/22)**

(54) **SYSTEME MODULAIRE DE CONVERSION D'UNE PUISSANCE ELECTRIQUE CONTINUE EN PUISSANCE ELECTRIQUE TRIPHASEE**

MODULARES SYSTEM ZUR UMWANDLUNG VON GLEICHSTROM IN DREIPHASIGEN STROM

MODULAR SYSTEM FOR CONVERTING A DC ELECTRICAL POWER INTO THREE-PHASE ELECTRICAL POWER

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **23.11.2015 FR 1561213**

(43) Date de publication de la demande:
**03.10.2018 Bulletin 2018/40**

(73) Titulaires:
• **IFP Energies nouvelles**
  **92500 Rueil-Malmaison (FR)**
• **Mavel S.r.l.**
  **11026 Pont Saint Martin (AO) (IT)**

(72) Inventeurs:
• **DIB, Wissam**
  **92150 Suresnes (FR)**
• **CHIONO, Denny**
  **11010 Saint Nicolas (AO) (IT)**
• **BETTONI, Davide**
  **10010 Settimo Vittone To Italy (IT)**

(74) Mandataire: **IFP Energies nouvelles**
  **Département Propriété Industrielle**
  **Rond Point de l'échangeur de Solaize**
  **BP3**
  **69360 Solaize (FR)**

(56) Documents cités:
DE-A1-102013 021 487     US-A1- 2006 268 585
US-A1- 2013 027 984      US-A1- 2015 311 815

• JONATHAN DOMINI SPERB ET AL:
  "Regenerative Undeland Snubber Using a ZVS PWM DC DC Auxiliary Converter Applied to Three-Phase Voltage-Fed Inverters", IEEE TRANSACTIONS ON INDUSTRIAL ELECTRONICS, IEEE SERVICE CENTER, PISCATAWAY, NJ, USA, vol. 58, no. 8, 1 août 2011 (2011-08-01), pages 3298-3307, XP011370069, ISSN: 0278-0046, DOI: 10.1109/TIE.2010.2089947

**Description**

La présente invention concerne le domaine des convertisseurs pour la conversion de l'énergie électrique, notamment pour les machines électriques à haute vitesse et/ou à vitesse variable.

Un convertisseur statique est un système permettant de convertir un signal électrique en un autre signal électrique possédant des caractéristiques différentes. Par exemple, un convertisseur peut permettre de convertir une tension alternative en une autre tension alternative avec une fréquence et/ou une amplitude différente, on parle alors de convertisseur alternatif/alternatif ou AC/AC. Selon un autre exemple, un convertisseur peut permettre de convertir une tension alternative en une tension continue, on parle alors de convertisseur alternatif/continu ou AC/DC. Pour la conversion inverse continu/alternatif, on parle de convertisseur DC/AC. Selon un dernier exemple, un convertisseur peut convertir une tension continue en une tension continue de tension différente, on parle alors de convertisseur DC/DC. Les convertisseurs peuvent être réversibles ou non réversibles. Généralement, la conversion est mise en œuvre au moyen de commutateurs (interrupteurs) commandés.

Pour piloter des machines électriques, notamment des machines électriques à aimants permanents, à partir de système(s) de stockage d'énergie électrique (par exemple une batterie), il est nécessaire de convertir l'énergie électrique continue en énergie alternative triphasée. Cette conversion peut être réalisée au moyen d'un convertisseur DC/AC. Un tel convertisseur doit fournir trois tensions sinusoïdales déphasées de 120° électriques les unes par rapport aux autres, dont l'amplitude dépend directement du couple demandé (mais aussi du régime de rotation), et dont la fréquence dépend uniquement du régime de rotation de la machine électrique reliée au convertisseur.

Classiquement, un convertisseur DC/AC comprend trois bras de commutations. Chaque bras de commutation comporte deux commutateurs commandés et deux diodes placées en parallèle des commutateurs commandés. En fonction du courant de charge demandé, un bras peut être composé de plusieurs 'sous bras' en parallèle. Les phases de la machine électrique sont reliées au point milieu de chaque bras. On commande chaque bras séparément en pilotant l'ouverture et la fermeture des commutateurs sur des périodes de découpage, de manière à former un signal triphasé.

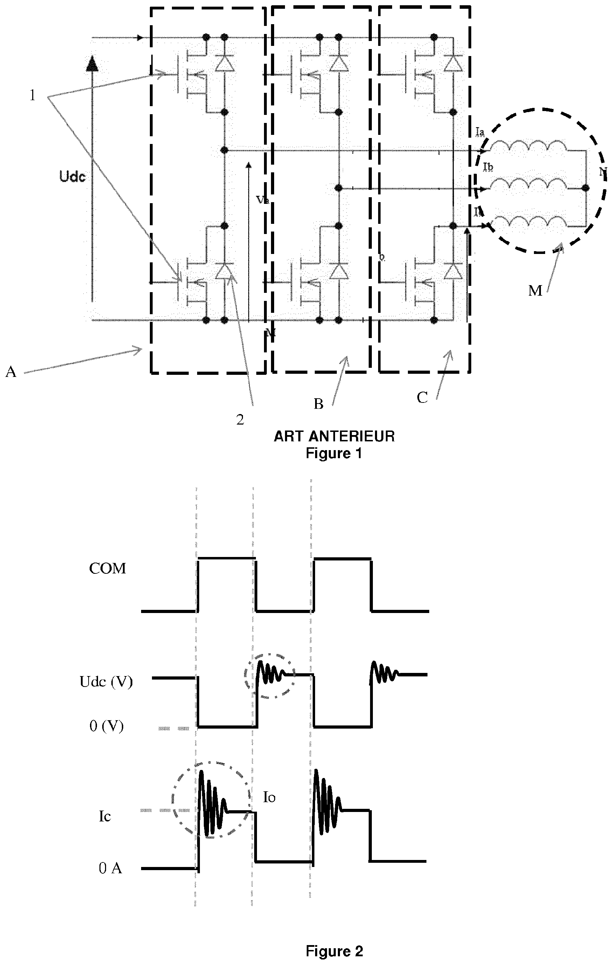

La figure 1 illustre un tel convertisseur classique DC/AC. La tension continue du moyen de stockage d'énergie électrique est indiquée Udc. Le moteur triphasé M est représenté schématiquement par trois bobines, alimentées par les courants Ia, Ib et Ic. Le convertisseur comporte trois bras de commutation A, B, C, chaque bras de commutation A, B, C est relié à une phase de la machine électrique M. Chaque bras de commutation comporte deux commutateurs 1 et deux diodes 2. Les bras de commutation A, B, C sont disposés en parallèle, entre les deux phases d'entrée continues du convertisseur de tension Udc. Les phases de sortie des bras de commutation A, B, C sont reliées au point milieu (entre les deux commutateurs) des bras de commutation.

La figure 2 représente le signal de commande COM des interrupteurs avec un rapport cyclique constant de 50%, la tension Udc et le courant Ic aux bornes d'un commutateur, pour un convertisseur DC/AC classique (tel que décrit ci-dessus en référence à la figure 1). Pour le signal de commande COM, la partie basse du créneau correspond au commutateur ouvert, et la partie haute du créneau correspond au commutateur fermé. On parle pour ce cas de commutation dite dure ou 'tout ou rien' (de l'anglais « hard switching »). On remarque que pour cette conception du convertisseur, des dépassements de la tension Udc et du courant Io apparaissent. Le courant Io correspond à la valeur permanente de Ic, et correspond au courant envoyé à la machine électrique.

Ainsi, les principaux inconvénients de cette conception classique du convertisseur sont les suivants :

- pertes par commutation : cette conception présente des pertes par commutation importantes, ce qui tend à rendre son utilisation incompatible à des fréquences de commutation élevées et donc pour des machines électriques utilisées à très hautes vitesses,
- dépassement de courant/tension : comme présenté sur la figure 2, cette stratégie présente des dépassements de tension (de l'anglais « overshoot ») et de courant lors de la commutation instantanée de l'interrupteur. Ainsi ce type de pilotage nécessite une prise de marge sur la tension et le courant des différents composants lors de la conception du convertisseur (appelé aussi onduleur). Cela implique un surdimensionnement des composants utilisés, (par exemple : pour une tension de bus continu de 300 Volt, on utilise un commutateur IGBT avec une tension nominale de 600 Volt), et
- émissions électromagnétiques importantes (CEM).

En partant des inconvénients de la stratégie « Hard switching » (pertes, incompatibilité avec les moteurs à hautes vitesses), une conception dite commutation douce (ou de l'anglais « Soft switching ») a été développée. Ainsi, pour limiter les dépassements du courant et de la tension sur les commutateurs, une bobine et un condensateur sont ajoutés sur le circuit précédent. La bobine module la variation du courant di/dt (« Turn-On »), et le condensateur module la variation de la tension dv/dt (« Turn-Off »). De plus, et dans le but d'assurer le fonctionnement du circuit, et donc un bilan énergétique nul, une résistance est rajoutée dans le circuit entre la tension de la source d'énergie utilisée et le circuit capacitif. Cette résistance permet d'assurer le fonctionnement de ce circuit et de rebaisser la tension au borne du circuit capacitif. Une telle conception de convertisseur DC/AC est décrite notamment dans la demande de brevet WO 11016854.

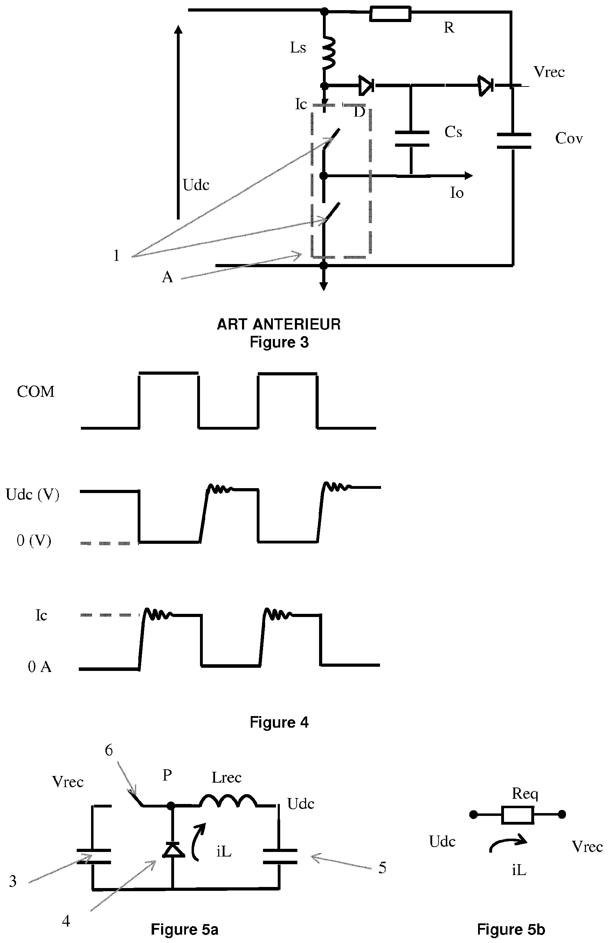

La figure 3 représente un schéma simplifié d'un bras de commutation (avec deux commutateurs 1) avec une capacité Cs, une bobine Ls, une résistance R et une capacité Cov pour une commutation douce. Ce circuit est connu par l'appellation anglaise « Undeland Snubber ». La tension Udc correspond à la tension aux bornes du moyen de stockage de l'énergie électrique continue. La bobine Ls est placée entre une phase d'entrée continue Udc et le bras de commutation A. Une branche part de la jonction entre la bobine Ls et le bras de commutation A, cette branche comporte deux diodes D, et arrive en une jonction entre la résistance R et le condensateur Cov. L'autre extrémité de la résistance R est connectée à la phase d'entrée continue du convertisseur. L'autre extrémité du condensateur Cs est connectée à la phase de sortie alternative du bras de commutation A. L'autre extrémité de la capacité Cov est connectée à la masse. La capacité Cs permet de moduler l'évolution de la tension aux bornes du commutateur. Cette capacité stocke une part de l'énergie due à la commutation douce des interrupteurs. L'autre partie de cette énergie est stockée dans une capacité d'une valeur plus élevée Cov. Ensuite, l'énergie stockée dans la capacité est renvoyée au système de stockage utilisé (batterie) à travers la résistance. La bobine Ls permet de moduler l'évolution du courant aux bornes du commutateur. En fait, l'énergie créée par la bobine Ls n'est pas en entièrement stockée dans la capacité Cs, d'où la nécessité d'une deuxième capacité Cov d'une valeur plus élevée que Cs. La résistance assure le fonctionnement du système et permet de rebaisser la tension Vrec.

La figure 4 présente, de manière similaire à la figure 2, le signal de commutation COM, l'évolution de la tension Udc et du courant Ic du commutateur lors d'une commutation dite « soft ». Pour le signal de commande COM, la partie basse du créneau correspond au commutateur ouvert, et la partie haute du créneau correspond au commutateur fermé. On remarque sur cette figure, que les dépassements de tension Udc et de courant Ic sont diminués par rapport à la commutation dite « hard ».

Les avantages de la commutation douce sont :

- moins de pertes par commutation, cette conception du convertisseur est compatible avec des fréquences de commutation élevées, ainsi, cette conception peut être utilisée pour piloter des machines électriques à hautes vitesses,
- peu de dépassement de tension et du courant sur le commutateur, donc plus besoin de surdimensionner les composants, et
- l'évolution de la tension et du courant aux bornes des commutateurs lors de la transition est modulée par le choix de Ls et Cs respectivement.

Cette conception du convertisseur nécessite un agencement particulier des différents composants électriques, ce qui rend leur montage long et complexe. Par ailleurs, cette conception du convertisseur présente un inconvénient majeur, qui est la nécessité de dissiper une énergie dans la résistance, dont l'objectif est de rendre le bilan énergétique des éléments passifs nul et donc de rebaisser la tension Vrec, ce qui implique des pertes énergétiques, et par conséquent une diminution de l'efficacité du convertisseur.

Le document US2015311815 A1 divulgue un contrôleur de puissance à semi-conducteurs à courant élevé ayant un premier circuit de commutateur de puissance à semi-conducteurs comprenant un commutateur de puissance à semi-conducteurs ayant une borne d'entrée à connecter une source d'alimentation et une borne de sortie pour alimenter un composant électrique. Un premier contrôleur est couplé électriquement au premier circuit, et un module de commande est couplé de manière opérationnelle au premier contrôleur. Une enceinte hermétique entoure le premier circuit.

Le document US20130027984 A1 divulgue un convertisseur alimenté en courant comportant une bobine connectée au côté primaire d'un transformateur, une source d'alimentation fournissant de l'énergie électrique au côté primaire du transformateur, un élément de commutation contrôlant un premier courant électrique circulant dans le transformateur. Le convertisseur comprend aussi une bobine, un circuit amortisseur qui comprend un élément redresseur et un élément capacitif qui est chargé par un second courant électrique circulant dans l'élément redresseur, et un circuit d'alimentation qui régénère la charge électrique de l'élément capacitif vers la source d'alimentation. Le circuit de protection contrôle une surtension qui est générée lorsque l'élément de commutation est désactivé. Le circuit d'alimentation maintient une tension de charge de l'élément capacitif à une valeur de tension prédéterminée.

Pour pallier ces inconvénients, la présente invention concerne un système de conversion d'une puissance électrique continue en puissance électrique alternative triphasée, selon la revendication 1. Le système de conversion comporte un assemblage sur une carte de circuit imprimé de plusieurs modules de puissance, d'un module de récupération d'énergie électrique, et d'une bobine. Ainsi, l'assemblage de différents modules sur une carte de circuit imprimé permet un montage simple et rapide du système de conversion. De plus, le module de puissance selon l'invention est adapté à une commutation douce, par la présence de la bobine, ce qui permet de minimiser les pertes par commutation, et de limiter les dépassements de tension et de courant. En outre, le module de récupération d'énergie électrique permet de réduire les pertes énergétiques.

**Le système selon l'invention**

L'invention concerne un système de conversion d'une puissance électrique continue en puissance électrique alternative triphasée comprenant trois bras de commutation. Ledit système de conversion comporte un assemblage sur une carte de circuit imprimé d'au moins un module de puissance par bras de commutation, d'un module de récupération d'énergie électrique, et d'une bobine pour une commutation douce.

Avantageusement, ledit assemblage est disposé dans un carter.

Selon une mise en œuvre de l'invention, lesdits modules de puissance comportent deux commutateurs, deux diodes et deux condensateurs.

Selon un mode de réalisation de l'invention, ledit module récupérateur d'énergie électrique comporte trois branches reliées en un point de jonction, avec :

- une première branche comportant un commutateur,
- une deuxième branche comportant une diode,
- une troisième branche comportant une inductance, et
- un condensateur.

Selon une variante de réalisation, chaque bras de commutation comporte une pluralité de modules de puissance associés, de préférence entre deux et quatre modules.

De manière avantageuse, lesdits modules de puissance, ladite bobine et ledit module de récupération d'énergie électrique sont montés d'un côté de ladite carte de circuit imprimé, et des condensateurs sont installés de l'autre côté de ladite carte de circuit imprimé.

Selon un mode de réalisation de l'invention, ledit système de conversion comporte un système de refroidissement, de préférence un circuit de refroidissement par liquide.

De préférence, ledit système de refroidissement est placé entre ladite carte du circuit imprimé et lesdits modules de puissance et de récupération de l'énergie électrique.

Conformément à une mise en œuvre de l'invention, ledit système de conversion comporte un circuit de mesure des tensions et/ou des courants.

Conformément à un mode de réalisation de l'invention, ladite bobine comporte plusieurs couches de cuivre obtenues par gravure chimique, et isolées au moyen d'un revêtement isolant.

De plus, ledit système de conversion peut comporter une carte de contrôle.

Conformément à un mode de réalisation, ledit système de conversion comporte une carte d'alimentation.

Selon un mode de réalisation de l'invention, ladite carte de circuit imprimé est une carte multicouche à haute densité de cuivre.

En outre, l'invention concerne un procédé de montage d'un système de conversion tel que défini dans la revendication 14. Pour ce procédé, on réalise les étapes suivantes :

a) on positionne au moins un module de puissance par bras de commutation, et un module de récupération d'énergie électrique ;

b) on assemble lesdits modules de puissance sur une carte de circuit imprimé ;

c) on assemble ledit module de récupération d'énergie électrique sur ladite carte de circuit imprimé ; et

d) on assemble une bobine sur ladite carte de circuit imprimé.

Avantageusement, on positionne lesdits modules de puissance et de récupération d'énergie électrique dans un carter.

De préférence, lesdits modules de puissance et de récupération d'énergie électrique, et la bobine sont assemblés à ladite carte de circuit imprimé par soudure, vissage et/ou encliquetage.

Selon une variante de réalisation, ledit procédé comporte une étape d'assemblage de condensateurs sur un côté de ladite carte de circuit imprimé opposé au côté de ladite carte de circuit imprimé sur laquelle lesdits modules de puissance et ledit module de récupération sont assemblés.

Conformément à un mode de réalisation de l'invention, ledit procédé comporte une étape d'assemblage d'un système de refroidissement entre ladite carte de circuit imprimé et lesdits modules de puissance et de récupération d'énergie électrique.

Selon un mode de réalisation, ledit procédé comporte au moins une étape pour l'installation d'un circuit de mesure et/ou d'une carte de contrôle et/ou d'une carte d'alimentation.

Un mode de réalisation est défini tel que le système moteur de la revendication 20. Il comprend au moins un moyen de stockage d'énergie électrique et une machine électrique triphasée. Le système moteur comporte un système de conversion tel que défini précédemment pour convertir l'énergie électrique continue dudit moyen de stockage de l'énergie électrique en énergie électrique alternative triphasée pour ladite machine électrique.

**Présentation succincte des figures**

D'autres caractéristiques et avantages du système selon l'invention, apparaîtront à la lecture de la description ci-après d'exemples non limitatifs de réalisations, en se référant aux figures annexées et décrites ci-après.

La figure 1, déjà décrite, illustre un convertisseur DC/AC classique, avec commutation dure, selon l'art antérieur.
La figure 2, déjà décrite, illustre le signal de commutation, la tension et l'intensité dans une phase pour un convertisseur DC/AC selon la conception de la figure 1.
La figure 3, déjà décrite, illustre un convertisseur DC/AC selon l'art antérieur, avec commutation douce.
La figure 4, déjà décrite, illustre le signal de commutation, la tension et l'intensité dans une phase pour un convertisseur DC/AC selon la conception de la figure 3.
La figure 5a illustre un exemple de réalisation du module récupérateur d'énergie électrique pour un convertisseur selon un mode de réalisation de l'invention.
La figure 5b illustre un modèle équivalent résistif au module récupérateur d'énergie électrique de la figure 5a.
La figure 6 illustre un schéma électrique d'un module de puissance selon un mode de réalisation de l'invention.
La figure 7 illustre la conception d'un module de puissance selon un mode de réalisation de l'invention.
La figure 8 illustre, selon une première vue, la carte de circuit imprimé équipée des modules de puissance selon un mode de réalisation de l'invention.
La figure 9 illustre, selon une deuxième vue, la carte de circuit imprimé équipée des modules de puissance selon un mode de réalisation de l'invention.
La figure 10 illustre, un carter pour le système de conversion d'énergie selon un mode de réalisation de l'invention.

**Description détaillée de l'invention**

La présente invention concerne un système de conversion (convertisseur) DC/AC permettant de convertir une énergie électrique continue en énergie électrique alternative triphasée. Avantageusement, le système de conversion selon l'invention, peut être bidirectionnel (réversible). Ainsi, au moyen du système de conversion selon l'invention, une énergie alternative triphasée peut être convertie en énergie électrique continue.

Classiquement, le système de conversion selon l'invention, comporte trois bras de commutation, une phase d'entrée continue, et trois phases de sorties alternatives. Chaque bras de convertisseur peut comprendre deux commutateurs (interrupteurs) commandés et deux diodes. De manière connue, la commande des commutateurs permet de générer une tension alternative. Les phases de sortie alternatives du système de conversion sont reliées au point milieu de chaque bras de commutation, c'est-à-dire entre les deux commutateurs.

Selon l'invention, le système de conversion comporte un assemblage sur une carte de circuit imprimé, appelée également carte PCB (de l'anglais « Printed Circuit Board ») :

- d'au moins un module de puissance par bras de commutation, le module de puissance comporte au moins deux commutateurs pour réaliser la conversion de la puissance continue en puissance alternative,
- d'au moins une bobine, qui assure la modulation de la variation de courant pour la commutation douce, et
- d'un module de récupération d'énergie électrique, qui permet de récupérer l'énergie disponible ou créée lors de la commutation dite douce, en récupérant l'énergie disponible lors de la commutation douce, et en l'envoyant vers des moyens de stockage d'énergie électrique (par exemple une batterie), connectés aux phases continues du système de conversion.

La carte de circuit imprimé permet notamment de relier électriquement les différents modules (de puissance et de récupération d'énergie électrique), ainsi que la bobine, sans l'utilisation de fil électrique. La carte de circuit imprimé est, de préférence, sensiblement plane et peut être de forme sensiblement rectangulaire. La carte de circuit imprimé peut être du type carte multicouche à haute densité de cuivre, de manière à optimiser sa conception. Dans ce cas, les lignes de courant sont incluses dans au moins une couche interne de la carte de circuit imprimé. Ce type de carte multicouche est adapté à des courants élevés. La carte de circuit imprimé peut comporter des fiches pour la connexion des entrées continues et des sorties alternatives du système de conversion. De plus, la carte de circuit imprimé peut comprendre des moyens de fixation pour l'assemblage des différents modules et de la bobine. Ces moyens de fixation peuvent être des orifices, des fentes et/ou des saillies.

On appelle module, un élément indépendant sous forme de bloc, qui regroupe tous les composants électroniques qui assurent une fonction. Ainsi, chaque module de puissance est un bloc qui comporte des moyens de commutation pour un bras de commutation, et le module de récupération d'énergie électrique est un bloc qui comporte des moyens électroniques permettant la récupération de l'énergie électrique. Cette réalisation sous forme de module, permet un assemblage simplifié et une modularité du système de conversion. En effet, les blocs peuvent être fabriqués séparément, et de manière standard, et le système de conversion est composé de différents modules (blocs) assemblés sur une carte de circuit imprimé. Ainsi, il n'est pas nécessaire d'assembler tous les composants électroniques du système de conversion sur un seul élément. De plus, cette réalisation sous forme de modules, permet de faciliter la maintenance : il est possible de remplacer uniquement un module défectueux sans à avoir à remplacer l'ensemble du convertisseur. Un autre avantage de cette conception est la possibilité d'utiliser des modules standards, qui peuvent être choisis en fonction de l'application souhaitée.

Selon un mode de réalisation, les différents modules (de puissance ou de récupération d'énergie électrique), ainsi que la bobine sont assemblés sur la carte de circuit imprimé par soudure, vissage et/ou encliquetage (« clipsage ») ou tout moyen analogue. Ces moyens d'assemblage permettent un assemblage rapide.

Les différents modes de réalisation, notamment la constitution des différents modules, décrits dans la description peuvent être combinés.

Chaque module de puissance sert de bras de commutation du système de conversion. Le module de puissance peut comporter :

- deux entrées, aptes à être connectées aux entrées continues du système de conversion, la première entrée peut être reliée à une tension positive, et la deuxième entrée peut être reliée à la masse,
- deux commutateurs montés en série entre les deux entrées, les commutateurs peuvent être commandés, de manière à fournir un courant de sortie alternatif,
- une sortie, apte à être connectée à une phase de sortie alternative du système de conversion, la sortie est connectée en un point entre les deux commutateurs,
- deux diodes, permettant le passage du courant selon une direction, et
- deux condensateurs, un premier condensateur dit condensateur de modulation de tension (qui permet la modulation de la variation de tension pour la commutation douce) et un deuxième condensateur (qui permet de stocker l'énergie créée qui n'est pas stockée dans le premier condensateur lors de la modulation de la tension).

Un tel module de puissance est compatible avec une large plage de fonctionnement de tension.

Selon un mode de réalisation de l'invention, le module de puissance contient uniquement ces composants électroniques : deux commutateurs, deux diodes, et deux condensateurs. Pour ce mode de réalisation, seul le deuxième condensateur peut être formé par une association en parallèle de plusieurs capacités (par exemple 2 ou 3 capacités).

En outre, le module de puissance est adapté à un système de conversion qui comporte un module récupérateur d'énergie électrique. Le module de puissance peut comprendre une deuxième sortie apte à être connectée au module récupérateur d'énergie électrique. Cette deuxième sortie peut être connectée à une diode.

Selon un mode de réalisation de l'invention, les diodes du module de puissance sont montées en série. Les diodes peuvent être connectées à une première entrée du module de puissance. Par exemple, l'entrée reliée à la tension positive. Dans le cas où le module de puissance comporte une deuxième sortie pour un module récupérateur d'énergie électrique, les diodes sont connectées à cette deuxième sortie.

De plus, le condensateur de modulation de tension peut être monté entre un point compris entre les deux diodes et la première sortie.

En outre, le deuxième condensateur peut être monté entre la deuxième sortie et la deuxième entrée du module de puissance, c'est-à-dire sur l'entrée du module de puissance, sur laquelle les diodes ne sont pas montées, par exemple cette deuxième entrée peut correspondre à la masse.

Conformément à un mode de réalisation de l'invention, les commutateurs des modules de puissance peuvent être des commutateurs de type MOSFET (acronyme anglais de « Metal Oxide Semiconductor Field Effect Transistor » qui se traduit par transistor à effet de champ à structure métal-oxyde-semi-conducteur) et/ou IGBT (transistor bipolaire à grille isolée de l'anglais « Insulated Gate Bipolar Transistor »), en fonction de la tension d'entrée du bus DC. Pour la haute tension, on peut utiliser des interrupteurs (commutateurs) IGBT. Pour la basse tension, on peut utiliser des interrupteurs MOSFET.

De préférence, les commutateurs peuvent être commandés par une méthode de modulation de largeur d'impulsion (MLI ou en anglais PWM pour « Puise Width Modulation »). Le principe général de cette méthode de modulation est qu'en appliquant une succession d'états discrets pendant des durées bien choisies, on peut obtenir en moyenne sur une certaine durée n'importe quelle valeur intermédiaire.

Pour la modulation des variations de la tension, le premier condensateur de modulation de tension peut avoir une valeur comprise entre 4 et 15 nF, de préférence entre 4 et 10 nF.

Le deuxième condensateur a, de préférence, une capacité plus élevée que le premier condensateur. Le deuxième condensateur peut avoir une valeur comprise entre 500 et 5000 nF, de préférence entre 600 et 2500 nF. Selon une variante de réalisation de l'invention, le deuxième condensateur peut être formé de plusieurs capacités associées en parallèle et/ou en série. De manière avantageuse, pour limiter l'encombrement, le deuxième condensateur peut être formé de trois capacités identiques (de même capacité) associées en parallèle.

Avantageusement, le module de puissance se présente sous la forme d'un bloc, de manière à faciliter son assemblage, sa compacité et sa standardisation. Le bloc peut comprendre un support, une plaque comprenant un circuit imprimé, et les composants électroniques (commutateurs, diodes, condensateurs) du module de puissance. La plaque peut être sous la forme d'un circuit imprimé. Les composants électroniques sont montés sur la plaque. La plaque est montée sur le support. Le bloc peut être agencé de manière à être monté sur la carte de circuit imprimé d'un système de conversion. Le bloc peut avoir une forme sensiblement parallélépipédique.

Conformément à une variante de réalisation de l'invention, le bloc peut comporter plusieurs moyens de fixation sur une carte d'un système de conversion. Les moyens de fixation peuvent être notamment au moins une encoche prévue pour le passage d'une vis. L'encoche peut être prévue dans le support et/ou la plaque du bloc. L'encoche peut être de forme sensiblement oblongue. Les moyens de fixation peuvent également comprendre au moins une fente ou une saillie, de manière à permettre une fixation par encliquetage (« clipsage ») ou pour permettre une mise en position du bloc.

Le bloc peut également comprendre des moyens de fixation pour la fixation de plusieurs modules entre eux, de manière à pouvoir associer plusieurs modules entre eux, notamment pour le cas où les courants sont élevés, ce qui permet de réaliser le bras de commutation d'un système de conversion sans employer des composants ayant des caractéristiques spécifiques élevées et étant onéreux.

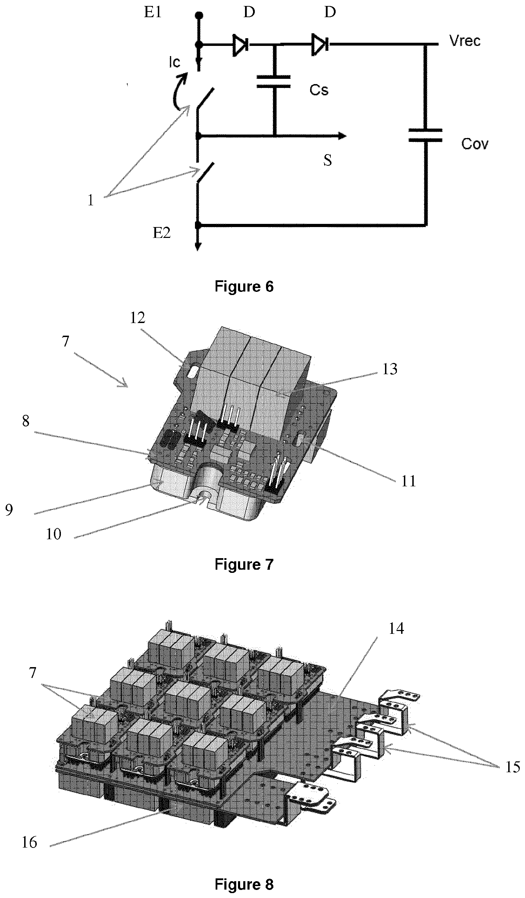

La figure 6 illustre, de manière non limitative, un schéma électrique d'un module de puissance selon un mode de réalisation de l'invention. Le module de puissance comporte deux entrées E1 et E2 destinées à être connectées aux entrées continues du système de conversion. L'entrée E1 peut correspondre à l'entrée de tension positive, et l'entrée E2 peut correspondre à la masse. Entre les deux entrées E1 et E2, deux commutateurs commandés 1 sont montées en série. Entre les deux commutateurs 1, la sortie S est connectée, cette sortie S est destinée à être connectée à une phase de sortie du système de conversion. Deux diodes D sont montées en série entre l'entrée E1 et la deuxième sortie Vrec, qui est apte à être connectée à un module récupérateur d'énergie électrique. Un premier condensateur Cs, destinée à la modulation de tension, est connecté en un point entre les deux diodes D et la première sortie S. Un deuxième condensateur Cov est connecté entre la deuxième sortie Vrec et la deuxième entrée E2.

La figure 7 illustre, schématiquement et de manière non limitative, un module de puissance selon un mode de réalisation de l'invention. Le module a sensiblement la forme d'un bloc 7. Le bloc 7 comporte une plaque 8, sous forme d'un circuit imprimé sur laquelle sont montées différents composants électroniques. La plaque 8 a sensiblement la forme d'un rectangle. La plaque 8 est montée sur un support 9. Le support 9 a sensiblement la forme d'un parallélépipède rectangle. La plaque 8 et le support 9 comportent plusieurs moyens de fixation : une encoche 10 prévue pour le passage d'une vis, et deux fentes 11 et 12 pour une fixation par encliquetage et/ou pour une mise en position du bloc. Des composants électroniques (représentés schématiquement) sont montées sur la plaque 8 du côté opposé au support 9. Parmi les composants électronique, le deuxième condensateur Cov est formé de trois condensateurs 13 associés en parallèle.

Le système de conversion peut comporter en outre un circuit de modulation de tension et d'intensité. Le circuit de modulation de tension et d'intensité permet une commutation douce (« soft switching »), ce qui permet de limiter les pertes par commutation, de limiter les dépassements de tension et de courant sur les commutateurs. Le circuit de modulation comporte une bobine, qui module la variation de courant, et un condensateur par phase, pour moduler la variation de tension. La bobine est montée directement sur la carte de circuit imprimé. Afin de maximiser la densité de cuivre dans l'enroulement de la bobine, l'enroulement peut être constitué par des couches de cuivre obtenues par gravure chimique et isolées par l'application d'un revêtement isolant, de manière à minimiser l'effet de peau qui pourrait avoir un effet nuisible pour les fréquences élevés. Chaque condensateur permettant la modulation est inclus dans un des modules de puissance.

Selon un mode de réalisation de l'invention, le circuit de modulation comporte une bobine qui relie une phase d'entrée continue du système de commutation et les bras de commutation.

Selon l'invention, le système de conversion comporte en outre un module récupérateur d'énergie électrique. Avantageusement, le module de récupération d'énergie électrique ne comprend pas de résistance. Ainsi, le système de conversion ne comporte pas de résistance, dans laquelle de l'énergie est dissipée pour l'art antérieur. Au contraire, le module récupérateur d'énergie électrique, qui remplace la résistance, permet de récupérer l'énergie disponible ou créée lors de la commutation dite douce, en récupérant l'énergie disponible lors de la commutation douce et en l'envoyant vers des moyens de stockage d'énergie électrique (par exemple une batterie), connectés aux phases continues du système de conversion. Le module de récupération d'énergie électrique a pour fonction de décharger les circuits de protection des commutateurs et de rendre cette énergie disponible sur le bus continu. Ainsi, les pertes électriques sont fortement réduites. Le module récupérateur d'énergie électrique est relié au bras de commutation et au circuit de modulation.

Selon une conception possible de l'invention, le module récupérateur d'énergie électrique peut comprendre au moins une inductance, au moins une diode, au moins un condensateur et au moins un commutateur. Le commutateur est commandé de manière à autoriser la récupération d'énergie et son transfert vers les moyens de stockage d'énergie électrique. Avantageusement, le circuit de récupération peut être réalisé avec une topologie abaisseur (en anglais « buck »).

Selon une variante de réalisation de l'invention, le module récupérateur d'énergie électrique peut comporter trois branches reliées en un point de jonction avec :

- une première branche comportant un commutateur,
- une deuxième branche comportant une diode, et
- une troisième branche comportant une inductance.

Ainsi, la carte du circuit imprimé du système de conversion peut être modifiée de manière spécifique pour utiliser la conception d'un convertisseur de commutation douce compatible avec des fréquences de commutation élevées, tout en minimisant les pertes dues au circuit passif rajouté pour assurer le fonctionnement du circuit de modulation.

Le module de récupération d'énergie électrique peut être réalisé sous la forme d'un bloc comprenant des moyens de fixation à la carte de circuit imprimé. La fixation peut être réalisée par soudure, vissage, encliquetage ou tout moyen analogue. Dans ce but, les moyens de fixation à la carte de circuit imprimé peuvent être au moins un orifice, par exemple pour le passage d'une vis, au moins une saillie, au moins une fente etc.

La figure 5a représente, de manière schématique et non limitative, un tel module récupérateur d'énergie électrique. Le module récupérateur d'énergie électrique comporte trois branches reliées en un point de jonction P, avec :

- une première branche avec un commutateur 6,
- une deuxième branche comportant une diode 4 (dans laquelle circule un courant iL en fonction de la tension à ses bornes), et
- une troisième branche comportant une inductance Lrec.

Sur la figure 5a, le condensateur 5 représente la capacité des moyens de stockage d'énergie électrique (batterie) et n'est pas un composant du module récupérateur. Le condensateur 5 est placé entre l'inductance Lrec et la masse.

De plus, le condensateur 3 représente la capacité Crec, et c'est un composant du module récupérateur. Le condensateur 3 est placé entre le commutateur et la masse.

La diode 4 est placée entre le point de jonction des trois branches et la masse.

En pilotant le commutateur (son rapport cyclique), on peut piloter le courant iL qui circule entre Vrec et Udc (le courant envoyé à la batterie).

Ainsi, en considérant l'ensemble formé par le module récupérateur et le condensateur des moyens de stockage d'énergie électrique, l'ensemble est formé de trois branches parallèles, placées entre le point P et la masse, avec :

- une première branche comportant le commutateur 6 et le condensateur 3,
- une deuxième branche comportant une diode 4, et
- une troisième branche comportant l'inductance Lrec et la capacité 5 des moyens de stockage de l'énergie électrique.

Quand le commutateur est fermé, la diode est dans un mode bloquée et le courant iL qui circule dans la bobine Lrec (représenté dans la figure 5a) est égal à $\frac{V_{rec}-U_{dc}}{L_{rec}}$

Quand le commutateur est ouvert, la diode est un mode passant est le courant iL qui circule dans la bobine Lrec (représenté dans la figure 5a) est égal à $\frac{-U_{dc}}{L_{rec}}$.

Ainsi, en pilotant le temps d'ouverture et de fermeture du commutateur, on peut piloter la valeur moyenne du courant iL, et avoir un fonctionnement équivalent d'un circuit résistif.

La figure 5b représente, de manière non limitative, un schéma électrique équivalent du module récupérateur d'énergie électrique illustré à la figure 5a. Ainsi, le module récupérateur d'énergie électrique est équivalent à une résistance équivalente Req, dans laquelle circule un courant iL, mais sans dissipation de l'énergie électrique.

Pour cette variante de réalisation, le courant moyen dans ce circuit peut être exprimé sous la forme suivante :

$$\bar{i} \cong \frac{V_{rec}-U_{dc}}{L_{rec}}\frac{T}{2} = \frac{V_{rec}-U_{dc}}{2*L_{rec}*Fsw} \cong \frac{V_{rec}-U_{dc}}{Req}$$

avec :

- T la période de commutation du commutateur,
- Vrec la tension de récupération,
- Udc la tension de la phase d'entrée continue,
- Lrec l'inductance du module récupérateur,
- Req la résistance équivalente
- Fsw représente la fréquence de commutation des interrupteurs.

De préférence, un tel module récupérateur d'énergie est monté dans le système de conversion équipé du circuit de modulation, de telle sorte que le module récupérateur d'énergie électrique est disposé entre une phase d'entrée continue du système de conversion et la jonction entre le bras de commutation et le condensateur du circuit de modulation. Pour le mode de réalisation de la figure 5a, le module récupérateur d'énergie électrique peut être connecté de telle sorte que :

- le point du module récupérateur relié à ladite phase d'entrée continue (de tension Udc) du système de conversion correspond au point de la troisième branche du module récupérateur entre l'inductance Lrec et le deuxième condensateur 5 (ce condensateur est la capacité de la batterie), et
- le point du module récupérateur relié à la jonction entre le bras de commutation (de tension Vrec) et le condensateur du circuit de modulation correspond au point de la première branche du module récupérateur entre le commutateur 6 et le premier condensateur 3.

Selon une mise en œuvre de l'invention, le système de conversion peut comprendre un carter, dans lequel est monté l'assemblage. Le carter peut comprendre plusieurs orifices : notamment deux pour les entrées continues, pour permettre la connexion avec le système de stockage d'énergie électrique, et trois pour les sorties alternatives, pour permettre la connexion avec les phases de la machine électrique. Avantageusement, le carter peut avoir une forme sensiblement parallélépipédique. De plus, le carter peut comprendre des moyens pour positionner les différents modules avant leur assemblage sur la carte de circuit imprimé. Le carter peut comporter en outre des emplacements pour les différents circuits et cartes pouvant faire partie du système de conversion.

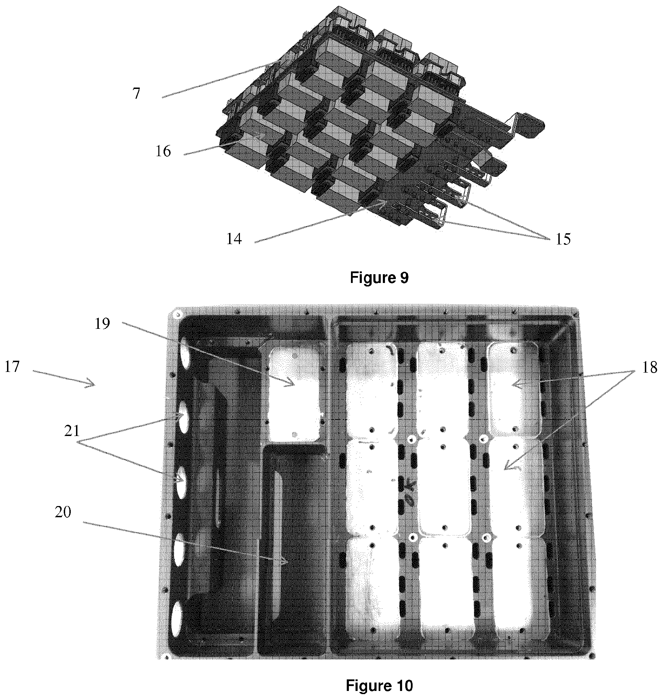

La figure 10 illustre, de manière non limitative, un carter, sans son couvercle, pour un système de conversion selon un mode de réalisation de l'invention. Le carter 17 a une forme parallélépipédique. Le carter 17 comporte plusieurs emplacements 18 destinés à recevoir les modules de puissance. Selon l'exemple illustré, le carter 17 comporte neuf emplacements 18 pour neuf modules de puissance (trois pour chaque bras de commutation). Le carter 17 comporte un emplacement 19 destiné à recevoir un module de récupération d'énergie électrique. Le carter 17 comporte, en outre, un emplacement 20 destiné à la bobine du circuit de commutation douce. De plus, le carter 17 comporte cinq orifices 21 pour la connexion des deux entrées continues et des trois sorties alternatives. Sur la figure, différents trous et fentes sont représentés, ils servent à l'assemblage des modules par rapport à la carte de circuit imprimé, et ceux situés sur le bord servent à la fixation du couvercle du carter.

Selon un mode de réalisation, la carte de circuit imprimé peut également comprendre des condensateurs appelés condensateurs de bus. Ces condensateurs de bus, permettent de découpler l'inductance du câble et l'inductance de la bobine du circuit de modulation. De manière à optimiser la surface de la carte de circuit imprimé, les condensateurs de bus sont montés sur la carte de circuit imprimé du côté opposé aux différents modules : les modules sont montés d'un côté de la carte et les condensateurs de bus sont montés de l'autre côté.

Les figures 8 et 9 illustrent, de manière non limitative, selon deux angles distincts, une carte de circuit imprimé 14, sur laquelle sont assemblés des modules de puissance 7 (ici neuf modules de puissance), et des condensateurs de bus 16. Selon la vue de la figure 8, les condensateurs de bus 16 sont assemblés en-dessous de la carte de circuit imprimé 14, alors que les modules de puissance 7 sont assemblés au-dessus de la carte de circuit imprimé 14. La carte de circuit imprimé comprend cinq fiches 15 pour la connexion des entrées continues et des sorties alternatives. Sur ces figures, le module de récupération d'énergie électrique, ainsi que la bobine ne sont pas représentés.

Selon un mode de réalisation de l'invention, le système de conversion comporte un système de refroidissement. Ainsi, il est possible d'éviter toute surchauffe des composants électroniques. De préférence, le système de refroidissement est un système de refroidissement liquide, qui comprend un circuit dans lequel circule le liquide. Toutefois, le système de refroidissement peut être un système de refroidissement par ventilation d'air ou par circulation d'air. Le circuit dans lequel circule le liquide peut avoir une forme d'un serpentin, de manière à optimiser la surface refroidie. Le circuit de liquide peut être placé entre la carte et les modules de puissance et de récupération d'énergie électrique, de manière à refroidir simultanément la carte de circuit imprimé et les différents modules.

Selon un mode de réalisation de l'invention, le système de conversion comporte une carte de contrôle. Selon un exemple la carte de contrôle peut être basée sur un DSP de Texas Instrument, et peut exécuter les fonctions suivantes :

- le conditionnement des lectures analogiques,
- la gestion des entrées et sorties,
- la gestion des protections, par exemple grâce à des moyens permettant de couper le système de conversion en cas de surtension ou de sur-courant, et
- la gestion de la modulation de la largeur d'impulsion (MLI ou PWM) pour les commutateurs des bras de commutation.

Selon une mise en œuvre de l'invention, le système de conversion peut comporter un circuit de mesure. Le circuit de mesure peut être formé d'une carte, pouvant comprendre plusieurs sous-cartes. Le circuit de mesure permet de mesurer les grandeurs nécessaires pour le contrôle, en particulier les tensions et/ou les courants de phase, et/ou la tension et le courant de bus, et/ou la tension du module récupérateur d'énergie électrique.

De plus, le système de conversion selon l'invention peut comprendre une carte d'alimentation, qui peut générer une onde carrée haute fréquence (par exemple 18 V à 130kHz), qui peut être utilisée par chaque carte (par exemple, la carte de contrôle, les sous-cartes du circuit de mesure) pour créer des niveaux de tension.

Le système de conversion selon l'invention permet de piloter des machines électriques, pour tous types d'application, en particulier pour des machines électriques tournant à de très hautes vitesses avec un rendement de l'onduleur (convertisseur) élevé.

Le convertisseur selon l'invention peut être prévu pour une utilisation embarquée, en particulier au sein d'un véhicule, notamment terrestre, aéronautique ou naval.

Le système de conversion selon l'invention peut également être utilisé dans les systèmes non embarqués de production d'énergie électrique, tels que des turbines, des micro-turbines ou des éoliennes.

Un mode de réalisation concerne un système moteur comprenant au moins un moyen de stockage d'énergie électrique, par exemple une batterie, et une machine électrique triphasée, par exemple une machine électrique à aimants permanents. Le système moteur comporte un système de conversion selon un des modes de réalisation décrits ci-dessus, pour convertir l'énergie électrique continue du moyen de stockage de l'énergie électrique en énergie électrique alternative triphasée pour la machine électrique, et éventuellement inversement. Ainsi, grâce au système de conversion, la machine électrique peut être pilotée, tout en limitant les pertes électriques. En outre, si le système de conversion est bidirectionnel (réversible), alors il est également possible de stocker (par exemple dans une batterie) une énergie électrique engendrée par la rotation de la machine électrique.

En outre, la présente invention concerne un procédé d'assemblage d'un système de conversion selon la revendication 14. Le procédé d'assemblage comporte les étapes suivantes :

a) on positionne, notamment au sein d'un carter, au moins un module de puissance par bras de commutation, et un module de récupération d'énergie électrique ;

b) on positionne une carte de circuit imprimé par rapport aux différents modules, et on assemble les modules de puissance sur la carte de circuit imprimé, par exemple par soudure, vissage, encliquetage ou tout moyen analogue ;

c) on positionne le module de récupération d'énergie électrique sur la carte de circuit imprimé, par exemple par soudure, vissage, encliquetage, ou tout moyen analogue ; et

d) on assemble une bobine sur la carte de circuit imprimé, par exemple par soudure, vissage, encliquetage, ou tout moyen analogue.

Les étapes b), c) et d) peuvent être réalisées selon un ordre quelconque ou simultanément.

En outre, le procédé peut comprendre une étape d'assemblage de condensateurs de bus sur la carte de circuit imprimé, du côté opposé de la carte, sur lequel les différents modules sont assemblés.

De plus, le procédé peut comprendre une étape de mise en place et d'assemblage d'un système de refroidissement. De préférence, le système de refroidissement, en particulier sous la forme d'un circuit de circulation de liquide, peut être placé entre la carte de circuit imprimé et les différents modules.

Par ailleurs, le procédé peut comprendre au moins une étape pour l'installation d'au moins un des éléments suivants : un circuit de mesure, une carte de contrôle, une carte d'alimentation.

Exemple comparatif :

Un exemple comparatif a été réalisé, de manière à comparer les pertes du système de conversion selon l'invention, avec les pertes des systèmes de conversion DC/AC selon l'art antérieur. Le système selon l'invention testé correspond au circuit selon mode de réalisation de la figure 5, avec un assemblage selon les modes de réalisation des figures 8 et 9. Les systèmes de conversion DC/AC de l'art antérieur correspondent respectivement à la commutation dure et à la commutation douce, respectivement selon les réalisations des figures 1 et 3.

Pour cet exemple, les valeurs utilisées pour un onduleur d'une puissance nominale de 50 kW, sont les suivantes :

- Ls ~=300 microH,

- Cs ~= 6.8 nanoF,

- Cov ~= 1410 nanoF,

- Vrec ~= 1.5 Vbus,

- Lrec = 56 microH,

- Crec = 20 nanoF,

- type de commutateur : IGBT.

*Tableau 1 - Exemple comparatif*

|  | Puissance fournie | Pertes totales | Pertes par dissipation dans le circuit ajouté | Pertes par commutation | Fréquence de commutation |
|---|---|---|---|---|---|
| Art antérieur Hard switching (Figure 1) | 50 kW | 2 kW | 0 kW | 2 kW | 20 khz |
| Art antérieur Soft switching (Figure 3) | 50 kW | 2 kW | 1 kW | 1 kW | 50 khz |
| Invention (Figure 5) | 50 kW | 1.15 kW | 0.15 kW | 1 kW | 50 khz |

On remarque que le système de conversion permet de réduire les pertes totales d'environ 42,5 % par rapport aux systèmes de conversion selon l'art antérieur. Cette réduction est due à une réduction des pertes par commutation liées à la commutation douce (réduction de 50 % des pertes par commutation par rapport à une commutation dure), et par une réduction des pertes par dissipation dans le circuit ajouté (réduction de 85 % des pertes par dissipation par rapport à une commutation douce).

**Revendications**

1.  Système de conversion d'une puissance électrique continue en puissance électrique alternative triphasée comprenant trois bras de commutation (A, B, C), **caractérisé en ce que** ledit système de conversion comporte un assemblage sur une carte de circuit imprimé (14) d'au moins un module de puissance (7) par bras de commutation (A, B, C), d'un module de récupération d'énergie électrique, et d'une bobine (Ls) pour une commutation douce, chaque module de puissance étant adapté pour réaliser la conversion de la puissance d'un courant continu en puissance d'un courant alternatif, la bobine étant adaptée pour assurer la modulation de la variation de courant pour la commutation douce, et le module de récupération d'énergie étant adapté pour récupérer l'énergie disponible ou créée lors de la commutation douce.

2.  Système selon la revendication 1, dans lequel ledit assemblage est disposé dans un carter (17).

3.  Système selon l'une des revendications précédentes, dans lequel lesdits modules de puissance (7) comportent deux commutateurs (1), deux diodes (D) et deux condensateurs (Cs, Cov).

4.  Système selon l'une des revendications précédentes, dans lequel ledit module récupérateur d'énergie électrique comporte trois branches reliées en un point de jonction (P), avec :

    - une première branche comportant un commutateur (6),
    - une deuxième branche comportant une diode (4),
    - une troisième branche comportant une inductance (Lrec), et
    - un condensateur (3).

**5.** Système selon l'une des revendications précédentes, dans lequel chaque bras de commutation comporte une pluralité de modules de puissance (7) associés, de préférence entre deux et quatre modules.

**6.** Système selon l'une des revendications précédentes, dans lequel lesdits modules de puissance (7), ladite bobine (Ls) et ledit module de récupération d'énergie électrique sont montés d'un côté de ladite carte de circuit imprimé (14), et des condensateurs (16) sont installés de l'autre côté de ladite carte de circuit imprimé (14).

**7.** Système selon l'une des revendications précédentes, dans lequel ledit système de conversion comporte un système de refroidissement, de préférence un circuit de refroidissement par liquide.

**8.** Système selon la revendication 7, dans lequel ledit système de refroidissement est placé entre ladite carte du circuit imprimé (14) et lesdits modules de puissance (7) et de récupération de l'énergie électrique.

**9.** Système selon l'une des revendications précédentes, dans lequel ledit système de conversion comporte un circuit de mesure des tensions et/ou des courants.

**10.** Système selon l'une des revendications précédentes, dans lequel ladite bobine (Ls) comporte plusieurs couches de cuivre obtenues par gravure chimique, et isolées au moyen d'un revêtement isolant.

**11.** Système selon l'une des revendications précédentes, dans lequel ledit système de conversion comporte une carte de contrôle.

**12.** Système selon l'une des revendications précédentes, dans lequel ledit système de conversion comporte une carte d'alimentation.

**13.** Système selon l'une des revendications précédentes, dans lequel ladite carte de circuit imprimé est une carte multicouche à haute densité de cuivre.

**14.** Procédé de montage d'un système de conversion selon l'une des revendications précédentes, comportant les étapes suivantes :

a) on positionne au moins un module de puissance (7) par bras de commutation, et un module de récupération d'énergie électrique ;
b) on assemble lesdits modules de puissance sur une carte de circuit imprimé (14) ;
c) on assemble ledit module de récupération d'énergie électrique sur ladite carte de circuit imprimé (14) ; et
d) on assemble une bobine (Ls) sur ladite carte de circuit imprimé (14),
chaque module de puissance étant adapté pour réaliser la conversion de la puissance d'un courant continu en puissance d'un courant alternatif, la bobine étant adaptée pour assurer la modulation de la variation de courant pour la commutation douce, et le module de récupération d'énergie étant adapté pour récupérer l'énergie disponible ou créée lors de la commutation douce.

**15.** Procédé selon la revendication 14, dans lequel on positionne lesdits modules de puissance (7) et de récupération d'énergie électrique dans un carter (17).

**16.** Procédé selon l'une des revendications 14 ou 15, dans lequel lesdits modules de puissance (7) et de récupération d'énergie électrique, et la bobine (Ls) sont assemblés à ladite carte de circuit imprimé par soudure, vissage et/ou encliquetage.

**17.** Procédé selon l'une des revendications 14 à 16, dans lequel ledit procédé comporte une étape d'assemblage de condensateurs (16) sur un côté de ladite carte de circuit imprimé (14) opposé au côté de ladite carte de circuit imprimé (14) sur laquelle lesdits modules de puissance (7) et ledit module de récupération sont assemblés.

**18.** Procédé selon l'une des revendications 14 à 17, dans lequel ledit procédé comporte une étape d'assemblage d'un système de refroidissement entre ladite carte de circuit imprimé et lesdits modules de puissance et de récupération d'énergie électrique.

**19.** Procédé selon l'une des revendications 14 à 18, dans lequel ledit procédé comporte au moins une étape pour l'installation d'un circuit de mesure et/ou d'une carte de contrôle et/ou d'une carte d'alimentation.

20. Système moteur comprenant au moins un moyen de stockage d'énergie électrique et une machine électrique triphasée (M), dans lequel le système moteur comporte un système de conversion selon l'une des revendications 1 à 13, pour convertir l'énergie électrique continue d'un moyen de stockage de l'énergie électrique en énergie électrique alternative triphasée pour une machine électrique.

**Patentansprüche**

1. System zur Umwandlung von Gleichstrom in dreiphasigen Wechselstrom, das drei Schaltarme (A, B, C) beinhaltet, **dadurch gekennzeichnet, dass** das Umwandlungssystem auf einer gedruckten Leiterkarte (14) eine Montageeinheit mit mindestens einem Leistungsmodul (7) pro Schaltarm (A, B, C), einem Modul zur Rückgewinnung von elektrischer Energie und einer Spule (Ls) für ein weiches Schalten umfasst, wobei jedes Leistungsmodul dazu ausgelegt ist, die Umwandlung der Leistung eines Gleichstroms in Leistung eines Wechselstroms durchzuführen, wobei die Spule dazu ausgelegt ist, die Modulation der Stromschwankungen für das weiche Schalten sicherzustellen, und wobei das Modul zur Rückgewinnung von Energie dazu ausgelegt ist, die während des weichen Schaltens verfügbare oder erzeugte Energie zurückzugewinnen.

2. System nach Anspruch 1, wobei die Montageeinheit in einem Gehäuse (17) angeordnet ist.

3. System nach einem der vorhergehenden Ansprüche, wobei die Leistungsmodule (7) zwei Schalter (1), zwei Dioden (D) und zwei Kondensatoren (Cs, Cov) umfassen.

4. System nach einem der vorhergehenden Ansprüche, wobei das Modul zur Rückgewinnung von elektrischer Energie drei Zweige umfasst, die in einem Anschlusspunkt (P) verbunden sind, mit:

   - einem ersten Zweig, der einen Schalter (6) umfasst,
   - einem zweiten Zweig, der eine Diode (4) umfasst,
   - einem dritten Zweig, der eine Induktivität (Lrec) umfasst und
   - einem Kondensator (3).

5. System nach einem der vorhergehenden Ansprüche, wobei jeder Schaltarm eine Vielzahl von assoziierten Leistungsmodulen (7), vorzugsweise zwei bis vier Module, umfasst.

6. System nach einem der vorhergehenden Ansprüche, wobei die Leistungsmodule (7), die Spule (Ls) und das Modul zur Rückgewinnung von elektrischer Energie auf einer Seite der gedruckten Leiterkarte (14) befestigt sind und Kondensatoren (16) auf der anderen Seite der gedruckten Leiterkarte (14) angebracht sind.

7. System nach einem der vorhergehenden Ansprüche, wobei das Umwandlungssystem ein Kühlsystem, vorzugsweise einen Flüssigkeitskühlkreislauf, umfasst.

8. System nach Anspruch 7, wobei das Kühlsystem zwischen der gedruckten Leiterkarte (14) und den Leistungsmodulen (7) und dem Modul zur Rückgewinnung von elektrischer Energie eingerichtet ist.

9. System nach einem der vorhergehenden Ansprüche, wobei das Umwandlungssystem eine Schaltung zum Messen der Spannungen und/oder der Ströme umfasst.

10. System nach einem der vorhergehenden Ansprüche, wobei die Spule (Ls) mehrere Kupferschichten umfasst, die durch chemisches Ätzen erhalten werden und die durch eine isolierende Beschichtung isoliert sind.

11. System nach einem der vorhergehenden Ansprüche, wobei das Umwandlungssystem eine Steuerkarte umfasst.

12. System nach einem der vorhergehenden Ansprüche, wobei das Umwandlungssystem eine Versorgungskarte umfasst.

13. System nach einem der vorhergehenden Ansprüche, wobei die gedruckte Leiterkarte eine mehrschichtige Karte mit hoher Kupferdichte ist.

14. Verfahren zur Befestigung eines Umwandlungssystems nach einem der vorhergehenden Ansprüche, das die folgenden Schritte umfasst:

a) Platzieren mindestens eines Leistungsmoduls (7) pro Schaltarm und eines Moduls zur Rückgewinnung von elektrischer Energie;
b) Montieren der Leistungsmodule auf einer gedruckten Leiterkarte (14);
c) Montieren des Moduls zur Rückgewinnung von elektrischer Energie auf der gedruckten Leiterkarte (14);
d) Montieren einer Spule (Ls) auf der gedruckten Leiterkarte (14),
wobei jedes Leistungsmodul dazu ausgelegt ist, die Umwandlung der Leistung eines Gleichstroms in Leistung eines Wechselstroms durchzuführen, wobei die Spule dazu ausgelegt ist, die Modulation der Stromschwankungen für das weiche Schalten sicherzustellen, und wobei das Modul zur Rückgewinnung von Energie dazu ausgelegt ist, die während des weichen Schaltens verfügbare oder erzeugte Energie zurückzugewinnen.

15. Verfahren nach Anspruch 14, wobei die Leistungsmodule (7) und das Modul zur Rückgewinnung von elektrischer Energie in einem Gehäuse (17) platziert werden.

16. Verfahren nach einem der Ansprüche 14 oder 15, wobei die Leistungsmodule (7) und das Modul zur Rückgewinnung von elektrischer Energie und die Spule (Ls) durch Schweißen, Verschrauben und/oder Einrasten auf der gedruckten Leiterkarte montiert werden.

17. Verfahren nach einem der Ansprüche 14 bis 16, wobei das Verfahren einen Schritt des Montierens von Kondensatoren (16) auf einer Seite der gedruckten Leiterkarte (14), die der Seite der gedruckten Leiterkarte (14), auf der die Leistungsmodule (7) und das Rückgewinnungsmodul montiert sind, gegenüberliegt, umfasst.

18. Verfahren nach einem der Ansprüche 14 bis 17, wobei das Verfahren einen Schritt des Montierens eines Kühlsystems zwischen der gedruckten Leiterkarte und den Leistungsmodulen und dem Modul zur Rückgewinnung von elektrischer Energie umfasst.

19. Verfahren nach einem der Ansprüche 14 bis 18, wobei das Verfahren mindestens einen Schritt zur Anbringung einer Messschaltung und/oder einer Steuerkarte und/oder einer Versorgungskarte umfasst.

20. Motorsystem, das mindestens ein Mittel zum Speichern von elektrischer Energie und eine elektrische Drehstrommaschine (M) beinhaltet, wobei das Motorsystem ein Umwandlungssystem nach einem der Ansprüche 1 bis 13 umfasst, um die elektrische Gleichstromenergie eines Mittels zum Speichern von elektrischer Energie in dreiphasige elektrische Wechselstromenergie für eine elektrische Maschine umzuwandeln.

**Claims**

1. System for converting a direct electrical power into three-phase alternating electrical power comprising three switching arms (A, B, C), **characterized in that** said conversion system comprises an assembly on a printed circuit board (14) of at least one power module (7) per switching arm (A, B, C), an electrical energy harvesting module and a coil (Ls) for soft switching, each power module being designed to convert the power of a direct current into power of an alternating current, the coil being designed to modulate the current variation for the soft switching, and the energy harvesting module being designed to harvest the energy available or created during the soft switching.

2. System according to Claim 1, in which said assembly is arranged in a housing (17).

3. System according to either of the preceding claims, in which said power modules (7) comprise two switches (1), two diodes (D) and two capacitors (Cs, Cov).

4. System according to one of the preceding claims, in which said electrical energy harvesting module comprises three branches linked at a junction point (P), with:

- a first branch comprising a switch (6),
- a second branch comprising a diode (4),
- a third branch comprising an inductor (Lrec), and
- a capacitor (3).

5. System according to one of the preceding claims, in which each switching arm comprises a plurality of associated power modules (7), preferably between two and four modules.

6. System according to one of the preceding claims, in which said power modules (7), said coil (Ls) and said electrical energy harvesting module are mounted on one side of said printed circuit board (14), and capacitors (16) are installed on the other side of said printed circuit board (14).

7. System according to one of the preceding claims, in which said conversion system comprises a cooling system, preferably a liquid cooling circuit.

8. System according to Claim 7, in which said cooling system is placed between said printed circuit board (14) and said power (7) and electrical energy harvesting modules.

9. System according to one of the preceding claims, in which said conversion system comprises a circuit for measuring voltages and/or currents.

10. System according to one of the preceding claims, in which said coil (Ls) comprises several copper layers obtained by chemical etching, and insulated by means of an insulating coating.

11. System according to one of the preceding claims, in which said conversion system comprises a control board.

12. System according to one of the preceding claims, in which said conversion system comprises a power supply board.

13. System according to one of the preceding claims, in which said printed circuit board is a high-density copper multilayer board.

14. Method for mounting a conversion system according to one of the preceding claims, comprising the following steps:

a) at least one power module (7) per switching arm and one electrical energy harvesting module are positioned;
b) said power modules are assembled on a printed circuit board (14);
c) said electrical energy harvesting module is assembled on said printed circuit board (14); and
d) a coil (Ls) is assembled on said printed circuit board (14), each power module being designed to convert the power of a direct current into power of an alternating current, the coil being designed to modulate the current variation for the soft switching, and the energy harvesting module being designed to harvest the energy available or created during the soft switching.

15. Method according to Claim 14, in which said power (7) and electrical energy harvesting modules are positioned in a housing (17).

16. Method according to either of Claims 14 and 15, in which said power (7) and electrical energy harvesting modules and the coil (Ls) are assembled with said printed circuit board by soldering, screw-fastening and/or snap-fitting.

17. Method according to one of Claims 14 to 16, in which said method comprises a step of assembly of capacitors (16) on a side of said printed circuit board (14) opposite the side of said printed circuit board (14) on which said power modules (7) and said harvesting module are assembled.

18. Method according to one of Claims 14 to 17, in which said method comprises a step of assembly of a cooling system between said printed circuit board and said power and electrical energy harvesting modules.

19. Method according to one of Claims 14 to 18, in which said method comprises at least one step for the installation of a measurement circuit and/or a control board and/or a power supply board.

20. Motor system comprising at least one electrical energy storage means and one three-phase electric machine (M), in which the motor system comprises a conversion system according to one of Claims 1 to 13, for converting the direct electrical energy from an electrical energy storage means into three-phase alternating electrical energy for an electric machine.

ART ANTERIEUR
Figure 1

Figure 2

**ART ANTERIEUR**
Figure 3

Figure 4

Figure 5a

Figure 5b

**Figure 6**

**Figure 7**

**Figure 8**

7

16

14

15

**Figure 9**

19

17

21

20

18

**Figure 10**

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 11016854 A
- US 2015311815 A1

- US 20130027984 A1